# EUROPEAN PATENT SPECIFICATION

(11) **EP 3 644 074 B1**
(45) Date of publication and mention of the grant of the patent: **08.04.2026**
(21) Application number: 18202805.0
(22) Date of filing: 26.10.2018
(51) Int. Cl.: G01R 31/12

(54) **OPTICAL DETECTOR FOR A HIGH-VOLTAGE CABLE ACCESSORY AND METHOD OF OPTICALLY MEASURING ELECTRICAL DISCHARGES**
OPTISCHER DETEKTOR FÜR HOCHSPANNUNGSKABELZUBEHÖR UND VERFAHREN ZUM OPTISCHEN MESSEN ELEKTRISCHER ENTLADUNGEN
DÉTECTEUR OPTIQUE POUR ACCESSOIRE DE CÂBLE HAUTE TENSION ET PROCÉDÉ DE MESURE OPTIQUE DE DÉCHARGES ÉLECTRIQUES

(43) Date of publication of application: 29.04.2020
(73) Proprietor: Tyco Electronics Raychem GmbH, 85521 Ottobrunn (DE)
(72) Inventor: EIGNER, Alexander, 81739 München (DE); KRANZ, Thomas, 81673 München (DE)
(74) Representative: Grünecker Patent- und Rechtsanwälte PartG mbB

(56) References cited:
- EP-A1- 3 109 958
- DE-A1- 102010 061 607
- US-A1- 2018 062 370
- SIEBLER DANIEL ET AL: "Elastomeric fluorescent POF for partial discharge detection: recent progress", VISUAL COMMUNICATIONS AND IMAGE PROCESSING; 20-1-2004 - 20-1-2004; SAN JOSE,, vol. 9634, 28 September 2015 (2015-09-28), pages 96343W - 96343W, XP060057282, ISBN: 978-1-62841-730-2, DOI: 10.1117/12.2194875

## Description

The present invention relates to an optical detector for a high-voltage cable accessory. The present invention further relates to a monitoring system for detecting an electrical discharge in a high-voltage cable accessory and to a method of detecting and/or monitoring electrical discharges occurring within an insulating part of such a high-voltage cable accessory.

High-voltage cable accessories are used to connect high-voltage power cables to electrical equipment such as overhead lines, transformers, surge arrestors, switchgears etc. High-voltage cable accessories either insulate or control the electrical field of power cables in different ambient conditions and are expected to have a lifetime of more than 40 years without any failure. In order to achieve this requirement, the insulation system and its performance must be checked regularly. Moreover, due to the fact that a manual installation is always necessary for erecting a termination or installing a cable joint, faults during the installation also have to be considered. Such mistakes can lead to an electrical breakdown with a subsequent arc inside the termination. Consequently, there is a need for a diagnostic method that provides information about the current status of the cable accessories, including their remaining lifetime.

The term "high-voltage" as used in the following is intended to relate to voltages above approximately 1 kV. In particular, the term high-voltage is intended to comprise the usual nominal voltage ranges of power transmission, namely medium voltage (about 3 kV to about 50 kV), high-voltage (about 50 kV to about 110 kV), and also extra high-voltage (up to presently about 500 kV). Of course also higher voltages may be considered in the future. These voltages may be direct current (DC) or alternating current (AC) voltages. In the following, the term "high-voltage cable" is intended to signify a cable that is suitable for carrying electric current of more than about 1 A at a voltage above approximately 1 kV. Accordingly, the term "high-voltage accessory" is intended to signify a device that is suitable for interconnecting high-voltage facilities and/or high-voltage cables. In particular, a high-voltage cable accessory may either be an end termination or a cable joint.

The most commonly used diagnostic method for providing real time information about the status and the remaining lifetime of cable accessories is the electrical partial discharge (PD) measurement. Electric discharges that do not completely bridge two electrodes or conductors in close proximity to each other are called "partial" discharges. The term "partial discharge" as used in the following therefore is intended to describe short term, low-energy and locally limited discharges within an insulation, which irreversibly damage the insulation but do not lead to a complete electric breakdown. The term "partial discharge" in particular is intended to comprise so-called "inner partial discharges" which occur within non-gaseous insulating materials. Originating with defects such as cavities or inclusions and interfaces to other materials, in particular to conductors carrying high-voltage, partial discharges lead to the formation of "trees" that grow over time and eventually cause an electric breakdown. Such PD trees typically have a length of more than 1 µm.

The magnitude of such partial discharges is usually small and the amount of charge transferred is in the range of 10 to a few hundred Pico-Coulombs (pC). For a partial discharge test, a suitably high AC or DC voltage is applied to the conductors surrounding the insulation material under test. Alternatively, the discharge can be detected under normal operating conditions depending on the defect and energized system characteristics.

Today, the most commonly used diagnostic method for obtaining the status of high-voltage cable accessories is the electrical partial discharge measurement according to the IEC standard 60270 ("High-voltage test techniques - Partial discharge measurement", IEC 60270:2000). This setup consists basically of a high-voltage source (which could be based on different techniques such as standard 50 Hz or resonant system), a coupling capacitance for signal extraction, and a quadrupole for the adaption of the PD signals for direct measurement. Each partial discharge event causes during the treeing process a short current signal which can be detected with the connected measuring device.

PD diagnostics is therefore based on the measurement of electrical signals with very small amplitude. A disadvantage of this technique is that due to the small amplitude it is very sensitive against electrical noise caused by external electrical fields such as from transformers, overhead lines, etc. Consequently, the electrical partial discharge measurement in a noisy environment (e.g. during on-site tests) does not always allow a proper interpretation of the partial discharge measurement results and thus an understanding of the condition of high-voltage equipment is not possible.

Partial discharges also produce light and therefore it is possible to detect partial discharges by measuring the light generated thereby. Such an optical PD measurement advantageously is not affected by electrical noise from the surrounding high-voltage equipment. For instance, by using fiber optic sensors that are integrated into high-voltage accessories, a real time damage monitoring based on an optical PD measurement could be demonstrated.

Such a fiber optic sensor arrangement using fluorescent optical fibers is for instance described in the article W. R. Habel et al.: "Fibre-optic sensors for early damage detection in plastic installations of high-voltage facilities", XVII International Symposium on High-voltage Engineering, Hannover, Germany, August 22-26, 2011. A detailed description of this system is also given in the PhD Thesis "Dielectric strength behavior and mechanical properties of transparent insulation materials suitable to optical monitoring of partial discharges" by Chaiyaporn Lothongkam, Fakultät für Elektrotechnik und Informatik der Gottfried Wilhelm Leibniz Universität Hannover, 25.7.2014 and similarly in German Patent Application No. DE 102010061607 A1.

Another fiber optic sensor arrangement is disclosed in European Patent Application No. 15173098.3. In EP 15173098.3, a field control element of a high-voltage cable accessory comprises an electrically insulating material that is at least partly provided with a fluorescent dye. The fluorescent dye is configured to convert a first radiation generated by an electrical discharge into a second radiation with a wavelength that is longer than the wavelength of the first radiation. Optical fibers are used to detect the second radiation.

US 2018/0062370 A1 discloses a high-voltage device for receiving a high-voltage cable having a conductor designed to conduct an electrical current and a cable insulation surrounding the conductor, includes an insulation and a waveguide. The insulation includes an at least partly transparent or translucent field control unit from a siloxane polymer which is designed to at least partly surround the cable insulation of the high-voltage cable, the siloxane polymer including, in at least one portion of the field control unit, covalently bonded fluorophores and/or dielectric pigments. The waveguide is arranged such that a light signal caused by a partial discharge in the field control unit can be coupled from the field control unit into the waveguide.

Existing fiber optic sensor arrangements use fluorescence, in either the optical fibers or the field control element of a high-voltage cable accessory, to shift a wavelength of the radiation generated by a partial discharge. It is necessary to shift the wavelength because conventional photodetectors are not sufficiently sensitive to properly detect the radiation from the electrical discharge at its naturally generated wavelength. The inclusion of fluorescent materials to enable the shift, however, can require specific and expensive procurement or production of fluorescent optical fibers or fluorescent insulating materials.

The object underlying the present invention is to overcome the drawbacks of the existing solutions and to provide a sensitive, accurate, and interference tolerant real time monitoring of partial discharges in electrical insulators capable of being produced more efficiently.

The object is solved by the subject matter of the independent claims. Advantageous embodiments of the present invention are the subject matter of the dependent claims.

The present invention is based on the idea that an easier detection of partial discharge can be accomplished by using an optical detector that is capable of directly detecting a radiation generated by an electrical discharge with satisfactory sensitivity. In particular, the present invention proposes to provide an optical detector for a high-voltage cable accessory, wherein the optical detector detects a radiation generated by an electrical discharge of the high-voltage cable accessory at a wavelength of the radiation generated by the electrical discharge.

Advantageously, by using an optical detector that is sufficiently sensitive to directly detect the radiation generated by the electrical discharge at the wavelength of the radiation, it is unnecessary to provide an element capable of shifting the wavelength of the radiation. Fewer components such as fluorescent materials or fluorescent dyes are then required for the accurate detection, and the optical detector and/or the high-voltage cable accessory can be produced more efficiently and more cost-effectively. The optical detector can be used with a conventionally produced high-voltage cable accessory to accurately detect electrical discharge. This leads to a simple installation of the optical detector and also permits an easy and efficient replacement of parts when necessary. Further, as the detection principle is based on an optical monitoring, it is not influenced by electrical noise effects or by electrical corona. The embodiments of the invention described herein can also be used for all voltage classes (AC and DC).

According to the present invention, the optical detector includes an optical transducer for generating an electrical signal from the detected radiation and an optical fiber for transmitting said radiation. Using the optical fiber to generate an electrical signal from the detected radiation eliminates the effects of electrical noise. Providing an optical fiber and a separate optical transducer has the advantage that the optical transducer may be arranged within a protected environment outside the high-voltage cable accessory and is therefore also not influenced by electric noise. The optical transducer may comprise a photodiode, for instance, to accurately convert the detected radiation into an electrical signal without increasing a necessary size of the optical detector.

The present invention further relates to a monitoring system for detecting an electrical discharge in a high-voltage cable accessory. The monitoring system comprises a high-voltage cable accessory and an optical detector according to the present invention. As already mentioned above, the term "high-voltage cable accessory" according to the present invention signifies a device that is used to connect high-voltage facilities with high-voltage cables or to interconnect high-voltage cables with each other. In particular, a high-voltage cable accessory may be a cable joint or an end termination. It comprises an insulating part that in the mounted state at least partly encompasses the cable insulation. As is known in the art, the insulating part usually comprises a field control element for controlling the electric field so that an electric field enhancement due to charge accumulation can be avoided. To this end, field control elements comprise areas with a field grading material, which comprises for instance a polymeric matrix and an electrically conducting organic filler forming a deflector of the field control element. Due to their geometric form, field control elements for high-voltage cable accessories are also often called "stress cones".

As described in detail in the PhD Thesis "Dielectric strength behavior and mechanical properties of transparent insulation materials suitable to optical monitoring of partial discharges" by Chaiyaporn Lothongkam, Fakultät für Elektrotechnik und Informatik der Gottfried Wilhelm Leibniz Universität Hannover, 25.7.2014, such field control elements are at least partly fabricated from a polysiloxane material. Other materials are also used for fabricating field control elements. Fabricating an insulating field control body of the field control element from a translucent or transparent polysiloxane permits sufficiently strong optical signals to be transferred to an outside of the field control element.

The deflector of the field control element is electrically conductive or semi-conductive and is positioned within the insulating field control body of the field control element in order to enhance the electrical noise resistance provided by the field control element. In an embodiment, the deflector is opaque and does not permit radiation generated by the electrical discharge to pass through the deflector in order to limit a necessary area of the field control element for detecting the radiation from the electrical discharge.

According to the present invention, the optical detector is formed to be mechanically and optically coupled with the field control element for optimally detecting the radiation. The field control element may have one or more openings for introducing the optical fiber. Alternatively, the optical fiber can also be arranged at an outer surface of the field control element, or the optical fiber can be both partially embedded in the field control element and partially arranged at the outer surface. A sensing region of the optical fiber is positioned along a path of an emitted light that does not intersect with the deflector in order to directly detect the radiation of the emitted light.

The present invention further relates to a method of detecting and/or monitoring electrical discharges occurring within an insulating part of a high-voltage cable accessory. The method comprises optically sensing a radiation generated by an electrical discharge of the high-voltage cable accessory at a wavelength of the radiation generated by the electrical discharge. In particular, the electrical discharge can be sufficiently detected without the need to provide an element capable of shifting the wavelength of the radiation. In an embodiment, the method is capable of detecting a radiation with a wavelength below 400 nm for optimal sensitivity and accuracy in detecting and/or monitoring the electrical discharges. Moreover, the method for detecting and/or monitoring electrical discharges can of course also be used with devices other than cable accessories.

The accompanying drawings are incorporated into the specification and form a part of the specification to illustrate several embodiments of the present invention. These drawings, together with the description serve to explain the principles of the invention. The drawings are merely for the purpose of illustrating the preferred and alternative examples of how the invention can be made and used. The invention is defined by the appended claims.

Further features and advantages will become apparent from the following more particular description of the various embodiments of the invention, as illustrated in the accompanying drawings, in which like references refer to like elements, and wherein:
- **Fig. 1**: is a schematic representation of a known high-voltage outdoor termination;
- **Fig. 2**: is a schematic representation of another embodiment of a known high-voltage outdoor termination;
- **Fig. 3**: is a schematic representation of a partial discharge and a radiation from the partial discharge in a field control element of the known high-voltage outdoor termination;
- **Fig. 4**: is a schematic representation of an optical fiber of an optical detector according to an embodiment of the invention positioned on a field control element to detect a radiation from a partial discharge;
- **Fig. 5**: is a schematic representation of a monitoring system according to the invention with an optical detector positioned to detect a radiation from a partial discharge in a high-voltage outdoor termination.

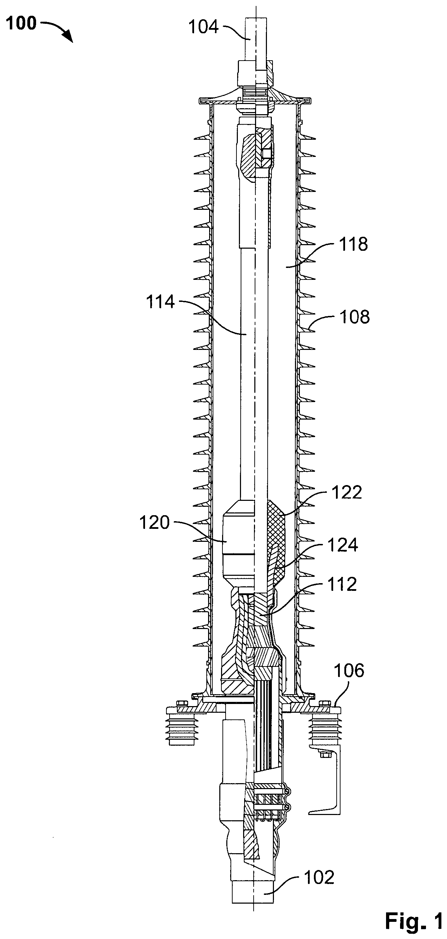

Fig. 1 shows a known high-voltage outdoor termination 100 as commonly used for overhead lines. The termination 100 provides a cable 102 with a cable lug 104 for connecting the cable 102 with, for example, high-voltage facilities. In some embodiments, the outdoor termination 100 is installed at a base plate 106. A housing 108, which may be fabricated from porcelain in an embodiment, encloses inner components of the termination 100 and protects the inner components from the surroundings. In other embodiments, the housing 108 may be fabricated from a silicone material.

The high-voltage cable 102, which is inserted into and connected within the cable end termination 100, is commonly stripped of its outer layers within the cable end termination 100. Outer layers of the cable 102 such as a cable jacket, cushioning layers, insulating layers, and a metallic shield may all be stripped from a portion of the cable 102 in order to expose a conductor 110 of the cable 102 within the termination 100. In the termination 100 shown in Fig. 1, a semi-conductive outer cable shield 112 of the cable 102 remains on a portion of the cable 102 within the housing 108, and at least a transition between an end of the stripped outer cable shield 112 and the conductor 110 is surrounded by a field control element 120 of the termination 110.

As generally known in the art, within the housing 108 there is an insulating area 118 which is filled with an electrically insulating filling. In various embodiments, the insulating filling in the insulating area 118 may comprise a gas, such as air or sulfur hexaflouride (SF₆), or a liquid, such as oil. In the shown embodiment, the insulating area 118 is essentially cylindrical and rotationally-symmetric.

The field control element 120, also referred to as a stress cone, is provided for controlling the electrical field at the transition between the conductor 110 of the cable 102 and the other outer layers of the cable 102. The field control element 120 is arranged at a location within the insulating area 118 at which an electrical field stress would be too high to be insulated by the insulating filling within the insulating area 118 alone.

The field control element 120, as shown in Fig. 1, includes an insulating field control body 122 and at least one electrically conductive or semi-conductive deflector 124. The deflector 124 is adapted to control the electrical field and influence an electrical field profile within a high-voltage cable accessory such as the termination 100. In an embodiment, the field control body 122 is formed from a transparent or translucent elastomeric material and the deflector 124 is integrated within the field control body 122. The field control body 122 may be formed from an electrically insulating polysiloxane. In an embodiment, the field control element 120 is formed as a cone with the integrated deflector 124 that is formed to deflect the electric field lines by geometric/capacitive effects so that the field strength outside the field control element 120 is reduced to uncritical values. The field control element 120 is formed with an inner hollow cylindrical opening for receiving the cable 102. The inner hollow cylindrical opening may be dimensioned to form a press fit between the cable insulation of the cable 102 and the field control element 120.

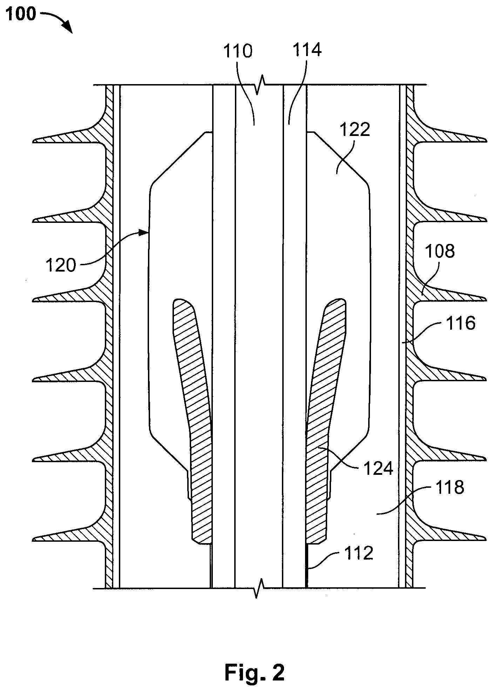

Fig. 2 shows another embodiment of a known high-voltage outdoor termination 100 as commonly used for overhead lines in greater detail around the field control element 120. In the embodiment shown in Fig. 2, a layer of cable inner insulation 114 remains around the conductor 110 of the cable 102 within the termination 100 and within the field control element 120. A glass fiber layer 116 is positioned at an interior side of the housing 108 and surrounds the insulating area 118 with the insulating filling. The glass fiber layer 116 provides an added resistance to external electrical fields. The deflector 124, shown in greater detail in Fig. 2, may be formed from an opaque electrically conductive or semi-conductive material that is substantially impenetrable to light radiation.

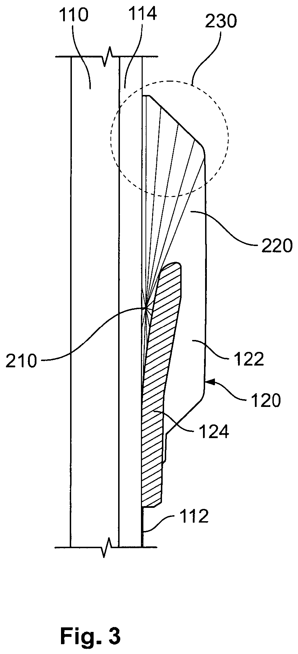

The present invention will now be explained in more detail with reference to Figures 3-5.

Optical partial discharge detection is based on the detection of the light which is generated as a result of the physical breakdown processes during the electrical discharge. The wavelength of the generated light depends on the insulating material where the discharges occur. The electrical discharge can be differentiated into three main insulating material groups which are used in high-voltage engineering: air, oil, and SF₆. The wavelength range for discharges in air is partly in the ultraviolet region and usually below 475 nm. In an embodiment, the wavelength range for discharges in air is below 400 nm. Discharges in oil cause a radiation emission in a wavelength region from about 380 nm to around 750 nm. Discharges occurring in SF₆ generate radiation in a wavelength range below 380 nm up to around 800 nm.

Within solid materials most of the discharges are related to air discharges as the void contains air or the failure is often caused by air entrapment. Partial electrical discharges commonly occur in an area of the stress cone or field control element 120 of the termination 100, which can be due to an improper installation of the field control element 120 or a defective termination of the cable 102 within the termination 100 that causes air entrapment. Discharges in other areas can also occur, for example, discharges in oil due to moisture ingress into the insulating area 118. A characteristic wavelength of a radiation from a partial electrical discharge in a plastic insulation such as the field control body 122 of the field control element 120 can be assumed to correspond to the wavelength of discharges in air.

A representative emission of light radiation from a partial electrical discharge in a field control element 120 is shown in Fig. 3. An electrical discharge source 210, as described above, commonly occurs as a result of entrapped air at the field control element 210 and, as shown in Fig. 3, is commonly positioned at a portion of the field control body 122 adjacent the conductor 110 where an electrical field is concentrated. The electrical discharge source 210 is also commonly positioned close to the deflector 124 due to the proximity to the end of the outer cable shield 112 of the cable 102. Of course, the electrical discharge source 210 could also occur in other portions of the field control body 122 and the field control element 210; the position of the electrical discharge source 210 shown in Fig. 3 is merely exemplary.

As shown in Fig. 3, at the occurrence of a partial electrical discharge, an emitted radiation 220 in the form of light travels along a plurality of emitted light paths in all radial directions extending from the electrical discharge source 210. The emitted radiation 220 passes through the transparent or translucent elastomeric material of the field control body 122. As shown in Fig. 3, a path of the emitted radiation 220 that intersects the cable inner insulation 114 or other portions of the cable 102 is blocked and cannot pass through the cable 102. Likewise, in the shown embodiment, a path of the emitted radiation 220 that intersects the deflector 124 is blocked by the opaque deflector 124 and cannot continue to pass through the field control element 210.

At least one path of the emitted radiation 220 travels through the field control body 122 unimpeded and reaches an outer surface of the field control body 122 at an area of emission 230 shown in Fig. 3. As described in greater detail below, an optical detector can be positioned at the area of emission 230 to detect and/or monitor the occurrence of electrical discharges by receiving the emitted radiation 220 from electrical discharge sources 210.

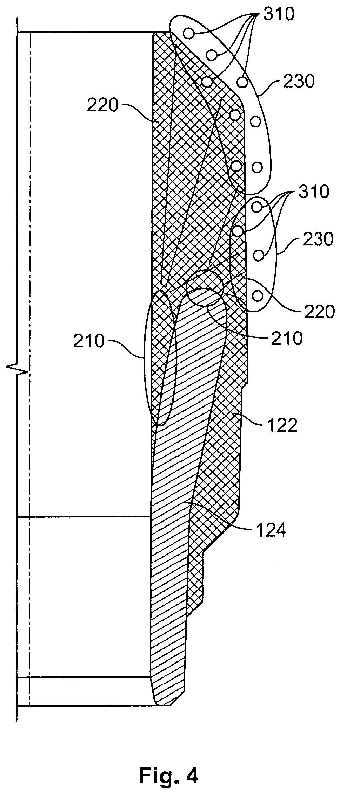

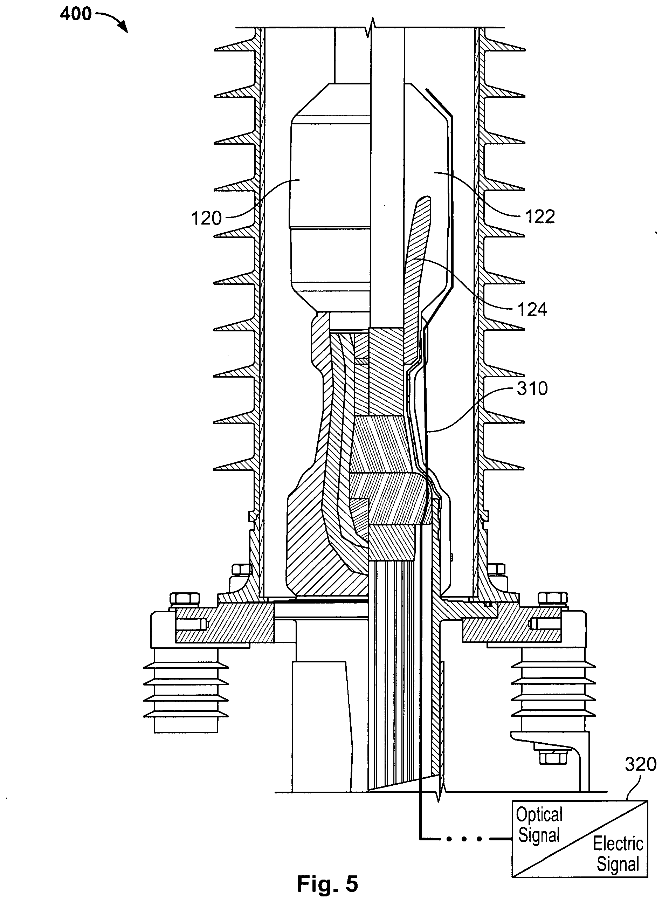

As shown in Figs. 4 and 5, an optical detector according to the invention includes an optical fiber 310 adapted to transmit a radiation and an optical transducer 320 connected to the optical fiber 310 adapted to receive the radiation from the optical fiber 310 and generate an electrical output signal from the radiation optical signal. In the shown embodiment, the optical fiber 310 is a polymeric optical fiber (POF).

As shown in Fig. 4, electrical discharge sources 210 corresponding to the occurrence of partial electrical discharges can occur at a plurality of positions within the field control body 122 and each emit an emitted radiation 220 that travels through the field control body 122 and reaches the outer surface of the field control body 122 at one of a plurality of areas of emission 230. The optical fiber 310 has a sensing region mechanically and optically coupled with the field control element 120 at the areas of emission 230 to detect the emitted radiation 220 from the electrical discharge sources 210. The sensing region of the optical fiber 310 is positioned along a path of the emitted radiation 220 that does not intersect with the deflector 124.

In the embodiment shown in Fig. 4, the sensing region of the optical fiber 310 is partially positioned on the outer surface of the field control body 122 and partially embedded within the field control body 122. The sensing region of the optical fiber 310 in the embodiment of Fig. 4 is wound circumferentially with respect to the outer surface of the field control body 122 in a direction substantially perpendicular to a longitudinal axis of the field control element 120. The field control body 122 may have one or more openings receiving the sensing region of the optical fiber 310, however, the optical fiber 310 must be disposed void-free in the field control body 122 to avoid the optical detector itself being a source of partial discharges.

In the embodiment shown in Fig. 5, the sensing region of the optical fiber 310 is positioned substantially entirely on the outer surface of the field control body 122 and extends parallel to the longitudinal axis of the field control element 210. In other embodiments, the sensing region of the optical fiber 310 may be entirely embedded within the field control body 122 or any proportion of the sensing region of the optical fiber 310 may be embedded in the field control body 122 or positioned on the outer surface of the field control body 122. Further, the sensing region of the optical fiber 310 may extend in any direction with respect to the longitudinal axis of the field control element 120. All embodiments of the optical fiber 310, regardless of the particular type of mechanical coupling arrangement, have the sensing region mechanically and optically coupled with the areas of emission 230 of the field control element 210.

In another embodiment, in order to ensure an optical reflection between the field control body 122 and the optical fiber 310, a separate layer with an optically optimized reflection behavior can be provided at the interface between the two surfaces. In another embodiment, the optical detector may comprise a photodetector directly arranged at the field control body 122 of the field control element 120.

A monitoring system 400 according to the invention is shown in Fig. 5 and comprises the optical detector coupled to the high-voltage outdoor termination 100. The sensing region of the optical fiber 310 gathers the emitted radiation 220 at the areas of emission 230 of the field control element 120 shown in Fig. 4 and transmits the radiation 220 to the optical transducer 320 shown in Fig. 5 via portions of the optical fiber 310 other than the sensing region.

The optical transducer 320, in an embodiment, is a photodiode for converting the radiation 220 received from the optical fiber 310 into an electrical signal. In another embodiment, the optical transducer 320 may be a charge coupled device (CCD). The electrical signal generated by the transducer 320 may be further processed by a central monitoring unit (not shown) of the optical detector which is configured to monitor the electrical signals transmitted from, for example, a plurality of such transducers 320.

According to the present invention, the optical transducer 320 is sufficiently sensitive to accurately convert detected radiation 220 having a very short wavelength. In an embodiment, the optical transducer 320 is capable of accurately converting detected radiation 220 having a wavelength below 400 nm into an electrical signal for analysis of partial electrical discharges in the field control element 210.

The optical detector according to the invention is consequently capable of directly detecting and monitoring radiation generated by discharges within air, or equivalently, discharges within the field control body 122 of the field control element 120. It is therefore unnecessary according to the present invention to shift the wavelength of the emitted radiation 220 to a larger wavelength to detect and monitor the electrical discharges in real time. Advantageously, the lack of a necessary shift in wavelength eliminates the need for additional shifting elements, such as fluorescent materials, easing production and enabling use of the optical detector with a known high-voltage cable accessory. Further, detection of the emitted radiation 220 at its naturally generated wavelength improves accuracy by avoiding losing or distorting any detected characteristics of the emitted radiation 220 during the conversion to a longer wavelength. The use of the optical detector further eliminates the influence of electrical noise on the detection of the emitted radiation 220.

The present invention is described above with reference to a high-voltage cable accessory in the form of a high-voltage outdoor termination 100. The termination 100 is merely exemplary and the present invention is not limited thereto; the optical detector and monitoring system 400 of the present invention are equally applicable to a switchgear termination designed to be installed in a cable entry housing of a gas insulated switchgear, a high-voltage cable joint adapted to connect two cables together, a transformer termination, and other types of high-voltage cable accessories known to those with ordinary skill in the art. Further, the optical detector and monitoring system 400 are applicable to a range of possible high voltages and can be used for all voltage classes. The optical detector and monitoring system 400 disclosed herein can be used with any enclosure that has a stress cone or field control element and in which the occurrence of partial electrical discharges is possible.

### REFERENCE NUMERALS

| **Reference Numeral** | **Description** |
|---|---|
| 100 | High-voltage outdoor termination |
| 102 | Cable |
| 104 | Cable lug |
| 106 | Base plate |
| 108 | Housing |
| 110 | Cable conductor |
| 112 | Outer cable shield |
| 114 | Cable insulation |
| 116 | Glass fiber layer |
| 118 | Insulating area with insulating filling |
| 120 | Field control element |
| 122 | Field control body |
| 124 | Deflector |
| 210 | Electrical discharge source |
| 220 | Emitted radiation |
| 230 | Area of emission |
| 310 | Optical fiber |
| 320 | Optical transducer |
| 400 | Monitoring system |

## Claims

1. Optical detector for a high-voltage cable accessory (100), wherein said optical detector comprises an optical transducer (320) for generating an electrical signal from a detected radiation (220) and an optical fiber (310) for transmitting said radiation;
**characterized in that**
the optical transducer (320) detects the radiation (220) generated by an electrical discharge (210) of the high-voltage cable accessory (100) directly at a wavelength of the radiation (220) generated by the electrical discharge (210), wherein the wavelength of radiation (220) is not shifted and wherein said radiation (220) has a wavelength region from below 380nm up to 800nm;
and wherein said optical fiber (310) does not have a fluorescent dye.

2. Optical detector according to claim 1, wherein said optical transducer (320) comprises a photodiode.

3. Monitoring system for detecting an electrical discharge (210) in a high-voltage cable accessory (100), said system comprising
a high-voltage cable accessory (100), and
an optical detector according to one of the preceding claims.

4. Monitoring system according to claim 3, wherein said high-voltage cable accessory (100) has a field control element (120) comprising an insulating field control body (122) and a deflector (124) disposed within said insulating field control body (122).

5. Monitoring system according to claim 4, wherein said insulating field control body (122) comprises at least one region of translucent or transparent polysiloxane.

6. Monitoring system according to claim 4 or 5, wherein said deflector (124) is electrically conductive or semi-conductive and is opaque.

7. Monitoring system according to any one of claims 4 to 6, wherein neither said field control element (120) nor said optical detector has a fluorescent dye.

8. Monitoring system according to any one of claims 4 to 7, wherein said optical detector is formed to be mechanically and optically coupled with said field control element (120) for detecting the radiation (220).

9. Monitoring system according to claim 8, wherein said optical fiber (310) has a sensing region which is positioned on an outer surface of the insulating field control body (122) or is at least partly embedded within the insulating field control body (122).

10. Monitoring system according to claim 9, wherein said sensing region of said optical fiber (310) is positioned along a path of the emitted radiation (220) that does not intersect with the deflector (124).

11. Monitoring system according to any one of claims 3 to 10, wherein said high-voltage cable accessory (100) is formed as an end termination or as a cable joint.

12. Method of detecting and/or monitoring electrical discharges (210) occurring within an insulating part (122) of a high-voltage cable accessory (100),
**characterized in that** said method comprises
optically sensing a radiation (220) generated by an electrical discharge (210) of the high-voltage cable accessory (100) by means of an optical fiber (310) having no fluorescent dye; transmitting the radiation (220) to an optical transducer (320) which detects the radiation (220) directly at a wavelength of the radiation (220) generated by the electrical discharge (210) and generates an electrical signal from the detected radiation (220), wherein the wavelength of radiation (220) is not shifted and wherein said radiation (220) has a wavelength region below 380nm up to 800nm.

## Patentansprüche

1. Optischer Detektor für ein Hochspannungskabelzubehör (100), wobei der optische Detektor einen optischen Wandler (320) zum Erzeugen eines elektrischen Signals aus einer erfassten Strahlung (220) und eine optische Faser (310) zum Übertragen der Strahlung umfasst;
**dadurch gekennzeichnet, dass**
der optische Wandler (320) die durch eine elektrische Entladung (210) des Hochspannungskabelzubehörs (100) erzeugte Strahlung (220) direkt bei einer Wellenlänge der durch die elektrische Entladung (210) erzeugten Strahlung (220) erfasst, wobei die Wellenlänge der Strahlung (220) nicht verschoben wird und wobei die Strahlung (220) einen Wellenlängenbereich von unter 380 nm bis zu 800 nm aufweist;
wobei die optische Faser (310) keinen Fluoreszenzfarbstoff enthält.

2. Optischer Detektor nach Anspruch 1, wobei der optische Wandler (320) eine Photodiode umfasst.

3. Überwachungssystem zum Erfassen einer elektrischen Entladung (210) in einem Hochspannungskabelzubehör (100), wobei das System Folgendes umfasst
ein Hochspannungskabelzubehör (100), und
einen optischen Detektor nach einem der vorhergehenden Ansprüche.

4. Überwachungssystem nach Anspruch 3, wobei das Hochspannungskabelzubehör (100) ein Feldsteuerelement (120) aufweist, das einen isolierenden Feldsteuerkörper (122) und einen Deflektor (124) umfasst, der innerhalb des isolierenden Feldsteuerkörpers (122) angeordnet ist.

5. Überwachungssystem nach Anspruch 4, wobei der isolierende Feldsteuerkörper (122) mindestens einen Bereich aus lichtdurchlässigem oder transparentem Polysiloxan umfasst.

6. Überwachungssystem nach Anspruch 4 oder 5, wobei der Deflektor (124) elektrisch leitend oder halbleitend und lichtundurchlässig ist.

7. Überwachungssystem nach einem der Ansprüche 4 bis 6, wobei weder das Feldsteuerelement (120) noch der optische Detektor einen Fluoreszenzfarbstoff aufweist.

8. Überwachungssystem nach einem der Ansprüche 4 bis 7, wobei der optische Detektor so ausgebildet ist, dass er mechanisch und optisch mit dem Feldsteuerelement (120) gekoppelt ist, um die Strahlung (220) zu erfassen.

9. Überwachungssystem nach Anspruch 8, wobei die optische Faser (310) einen Erkennungsbereich aufweist, der auf einer Außenfläche des isolierenden Feldsteuerkörpers (122) positioniert ist oder zumindest teilweise in den isolierenden Feldsteuerkörper (122) eingebettet ist.

10. Überwachungssystem nach Anspruch 9, wobei der Erkennungsbereich der optischen Faser (310) entlang eines Pfades der emittierten Strahlung (220) positioniert ist, der sich nicht mit dem Deflektor (124) schneidet.

11. Überwachungssystem nach einem der Ansprüche 3 bis 10, wobei das Hochspannungskabelzubehör (100) als Endabschluss oder als Kabelverbindung ausgebildet ist.

12. Verfahren zum Erfassen und/oder Überwachen von elektrischen Entladungen (210), die innerhalb eines isolierenden Teils (122) eines Hochspannungskabelzubehörs (100) auftreten,
**dadurch gekennzeichnet, dass**
das Verfahren umfasst
optisches Erkennen einer durch eine elektrische Entladung (210) des Hochspannungskabelzubehörs (100) erzeugten Strahlung (220) mittels einer optischen Faser (310), die keinen Fluoreszenzfarbstoff aufweist; Übertragen der Strahlung (220) zu einem optischen Wandler (320), der die Strahlung (220) direkt bei einer Wellenlänge der durch die elektrische Entladung (210) erzeugten Strahlung (220) erfasst und ein elektrisches Signal von der erfassten Strahlung (220) erzeugt, wobei die Wellenlänge der Strahlung (220) nicht verschoben wird und wobei die Strahlung (220) einen Wellenlängenbereich unter 380 nm bis zu 800 nm aufweist.

## Revendications

1. Détecteur optique pour un accessoire de câble à haute tension (100), dans lequel ledit détecteur optique comprend un transducteur optique (320) pour générer un signal électrique à partir d'un rayonnement détecté (220) et une fibre optique (310) pour transmettre ledit rayonnement ;
**caractérisé en ce que**
le transducteur optique (320) détecte le rayonnement (220) généré par une décharge électrique (210) de l'accessoire de câble à haute tension (100) directement à une longueur d'onde du rayonnement (220) généré par la décharge électrique (210), dans lequel la longueur d'onde du rayonnement (220) n'est pas décalée et dans lequel ledit rayonnement (220) présente une région de longueur d'onde allant de moins de 380 nm jusqu'à 800 nm ;
et dans lequel ladite fibre optique (310) ne présente pas de colorant fluorescent.

2. Détecteur optique selon la revendication 1, dans lequel ledit transducteur optique (320) comprend une photodiode.

3. Système de surveillance pour détecter une décharge électrique (210) dans un accessoire de câble à haute tension (100), ledit système comprenant
un accessoire de câble à haute tension (100), et
un détecteur optique selon l'une des revendications précédentes.

4. Système de surveillance selon la revendication 3, dans lequel ledit accessoire de câble à haute tension (100) présente un élément de commande de champ (120) comprenant un corps de commande de champ isolant (122) et un déflecteur (124) disposé à l'intérieur dudit corps de commande de champ isolant (122).

5. Système de surveillance selon la revendication 4, dans lequel ledit corps de commande de champ isolant (122) comprend au moins une région de polysiloxane translucide ou transparent.

6. Système de surveillance selon la revendication 4 ou 5, dans lequel ledit déflecteur (124) est électriquement conducteur ou semi-conducteur et est opaque.

7. Système de surveillance selon l'une quelconque des revendications 4 à 6, dans lequel ni ledit élément de commande de champ (120) ni ledit détecteur optique ne présentent de colorant fluorescent.

8. Système de surveillance selon l'une quelconque des revendications 4 à 7, dans lequel ledit détecteur optique est formé pour être couplé mécaniquement et optiquement audit élément de commande de champ (120) afin de détecter le rayonnement (220).

9. Système de surveillance selon la revendication 8, dans lequel ladite fibre optique (310) présente une région de détection qui est positionnée sur une surface extérieure du corps de commande de champ isolant (122) ou est au moins partiellement intégrée dans le corps de commande de champ isolant (122).

10. Système de surveillance selon la revendication 9, dans lequel ladite région de détection de ladite fibre optique (310) est positionnée le long d'un trajet du rayonnement émis (220) qui ne croise pas le déflecteur (124).

11. Système de surveillance selon l'une quelconque des revendications 3 à 10, dans lequel ledit accessoire de câble à haute tension (100) est formé comme une terminaison d'extrémité ou comme un joint de câble.

12. Procédé de détection et/ou de surveillance de décharges électriques (210) se produisant à l'intérieur d'une partie isolante (122) d'un accessoire de câble à haute tension (100),
**caractérisé en ce que**
ledit procédé comprend une détection optique d'un rayonnement (220) généré par une décharge électrique (210) de l'accessoire de câble à haute tension (100) au moyen d'une fibre optique (310) ne présentant pas de colorant fluorescent ; une transmission du rayonnement (220) à un transducteur optique (320) qui détecte le rayonnement (220) directement à une longueur d'onde du rayonnement (220) généré par la décharge électrique (210) et génère un signal électrique à partir du rayonnement détecté (220), dans lequel la longueur d'onde du rayonnement (220) n'est pas décalée et dans lequel ledit rayonnement (220) présente une région de longueur d'onde allant de moins de 380 nm jusqu'à 800 nm.
